# EUROPÄISCHE PATENTSCHRIFT

(11) **EP 1 384 272 B1**
(45) Veröffentlichungstag und Bekanntmachung des Hinweises auf die Patenterteilung: **22.06.2005**
(21) Anmeldenummer: 02729880.1
(22) Anmeldetag: 26.04.2002
(51) Int. Cl.: H01L 41/047, H01L 41/083

(54) **WEITERKONTAKTIERUNG FÜR EIN ELEKTRISCHES BAUTEIL SOWIE PIEZOELEKTRISCHES BAUTEIL IN VIELSCHICHTBAUWEISE**
ADDITIONAL CONTACTING FOR AN ELECTRIC COMPONENT AND PIEZOELECTRIC COMPONENT IN THE FORM OF A MULTILAYER STRUCTURE
SYSTEME DE CONTACT SUPPLEMENTAIRE POUR COMPOSANT ELECTRIQUE ET COMPOSANT PIEZO-ELECTRIQUE A STRUCTURE MULTICOUCHE

(30) Priorität: 30.04.2001 DE 10121272
(43) Veröffentlichungstag der Anmeldung: 28.01.2004
(73) Patentinhaber: SIEMENS AKTIENGESELLSCHAFT, 80333 München (DE)
(72) Erfinder: LUBITZ, Karl, 85521 Ottobrunn (DE); WOLFF, Andreas, 81825 München (DE); STEINKOPFF, Thorsten, 85614 Eglharting (DE); SCHUH, Carsten, 85598 Baldham (DE)
(86) Internationale Anmeldenummer: PCT/DE2002/001545
(87) Internationale Veröffentlichungsnummer: WO 2002/089226

(56) Entgegenhaltungen:
- WO-A-00/57497
- WO-A-00/63980
- WO-A-00/79607
- DE-C- 19 715 488
- US-A- 5 087 848

## Beschreibung

Die vorliegende Erfindung betrifft zunächst eine Weiterkontaktierung für ein elektrisches Bauteil, insbesondere für ein piezoelektrisches Bauteil in Vielschichtbauweise gemäß dem Oberbegriff von Patentanspruch 1. Weiterhin betrifft die Erfindung ein piezoelektrisches Bauteil in Vielschichtbauweise gemäß dem Oberbegriff von Patentanspruch 9.

Piezoelektrische Bauteile können als Vielschichtbauelemente mit einer Anzahl von jeweils alternierend angeordneten piezoelektrischen Keramikschichten und Elektrodenschichten ausgebildet sein und gewinnen in der modernen Elektrotechnik immer mehr an Bedeutung. Beispielsweise werden piezoelektrische Bauteile in Form von Piezoaktoren als Stellantriebe, in Verbindung mit Ventilen und dergleichen eingesetzt.

Ein bekannter Piezoaktor ist beispielsweise in der DE 196 46 676 C1 beschrieben. Bei derartigen Piezokeramiken wird der Effekt ausgenutzt, daß diese sich unter einem mechanischen Druck, beziehungsweise Zug, aufladen und andererseits bei Anlegen einer elektrischen Spannung entlang der Hauptachse der Keramikschicht ausdehnen. Zur Vervielfachung der nutzbaren Längenausdehnung werden beispielsweise monolithische Vielschichtaktoren verwendet, die aus einem gesinterten Stapel dünner Folien aus Piezokeramik (beispielsweise Bleizirkonattitanat) mit eingelagerten metallischen Elektrodenschichten bestehen. Die Elektrodenschichten sind wechselseitig aus dem Stapel herausgeführt und über Außenmetallisierungen elektrisch parallel geschaltet. Auf den beiden Kontaktseiten des Stapels ist hierzu jeweils eine streifen- oder bandförmige, durchgängige Metallisierung aufgebracht, die mit allen Elektrodenschichten gleicher Polarität verbunden ist. Zwischen der Metallisierung und den elektrischen Anschlußelementen des piezoelektrischen Bauteils wird häufig noch eine in vielen Formen ausführbare Weiterkontaktierung aufgebracht. Legt man eine elektrische Spannung an die elektrischen Anschlußelemente an, so dehnen sich die Piezofolien in Feldrichtung aus. Durch die mechanische Serienschaltung der einzelnen Piezofolien wird die Nenndehnung des gesamten Stapels schon bei relativ niedrigen elektrischen Spannungen erreicht.

Derartige Aktoren sind durch den mechanischen Hub einer erheblichen Belastung ausgesetzt. Von entscheidender Bedeutung für die Lebensdauer derartiger Aktoren im dynamischen Betrieb ist, zur Erzielung hoher Zyklenzahlen und hoher Zuverlässigkeit, die elektrische Außenkontaktierung. Multi-Layer-Aktoren aktueller Bauform enthalten bis zu mehreren hundert Elektrodenschichten, die beispielsweise durch Siebdrucken einer Silber-Palladium-Paste und anschließendes Co-Firing mit den Keramikschichten erzeugt werden. Diese Elektrodenschichten müssen zuverlässig und dauerhaft mit den externen elektrischen Anschlußelementen verbunden werden. Da auch eine durchgängige Metallisierung im dynamischen Betrieb an einzelnen Stellen unterbrochen werden kann, beispielsweise durch auftretende Risse oder dergleichen, muß die Weiterkontaktierung, beziehungsweise die Verbindung der Metallisierung mit den nach außen führenden elektrischen Anschlußelementen über eine größere Anzahl paralleler Verbindungselemente erfolgen, bei denen es sich beispielsweise um dünne Leiterbahnen, Drähte oder dergleichen handeln kann.

Eine solche Weiterkontaktierung ist beispielsweise in der von der Anmelderin ebenfalls eingereichten, älteren Patentanmeldung DE 198 18 068 offenbart. Darin sind die Elektrodenschichten einer Polarität eines piezoelektrischen Aktors zunächst über eine durchgehende Metallisierung miteinander verbunden. Zur Verbindung der Metallisierung mit elektrischen Anschlüssen ist eine Reihe von Verbindungselementen vorgesehen.

Die Lebensdauer und Zuverlässigkeit eines solchen piezoelektrischen Bauteils im dynamischen Betrieb hängt entscheidend von der Qualität der Weiterkontaktierung ab. Beispielsweise kann in den Verbindungselementen, etwa den Leiterbahnen, Drähten oder dergleichen, Materialermüdung auftreten. Weiterhin kann eine solche Materialermüdung auch in den Verbindungsbereichen der Verbindungselemente zur Metallisierung oder zu den elektrischen Anschlußelementen auftreten. Die Höhe der zur Ermüdung führenden zyklischen mechanischen Belastungen wird bei gegebener Materialauswahl durch den Hub des piezoelektrischen Vielschichtbauelements relativ zum ruhenden Anschlußelement sowie durch mögliche Longitudinal- beziehungsweise Transversalresonanzen der elektrischen Anschlußelemente, bei denen es sich beispielsweise um Kontaktstifte handelt, selbst bestimmt.

Diese im dynamischen Betrieb entstehenden Longitudinal- oder Transversalschwingungen verursachen im Bereich der Weiterkontaktierung zusätzliche mechanische Belastungen.

Aus der WO 00/63980 A ist eine Weiterkontaktierung eines piezoelektrischen Bauteils in monolithischer Vielschichtbauweise bekannt, das als ein einziges strukturiertes Bauteil ausgebildet ist. Das strukturierte Bauteil ist ein Doppelkamm aus einem Metallblech.

Aus der WO 00/79607 A ist ein piezoelektrisches Bauteil in monolithischer Vielschichtbauweise mit einer netzartigen Außenelektrode gekannt, die an einer seitlich am Aktor flächig angeordneten Metallisierung angebracht ist. Zur elektrischen Kontaktierung der Außenelektrode ist ein elektrisches Anschlusselement an die Außenelektrode angelötet.

Aus der US 5 087 848 A ist ein piezoelektrisches Bauteil in Vielschichtbauweise bekannt, bei dem piezokeramische Schichten und Elektrodenschichten übereinander gestapelt und in einem Lötprozess miteinander verbunden sind. Das Bauteil ist nicht-monolithisch. Die Elektrodenschichten sind mit Hilfe einer mehrteiligen Außenelektrode einzeln kontaktiert.

Ausgehend vom genannten Stand der Technik liegt der vorliegenden Erfindung die Aufgabe zu Grunde, eine Weiterkontaktierung für ein elektrisches Bauteil sowie ein piezoelektrisches Bauteil in Vielschichtbauweise der eingangs genannten Art derart weiterzubilden, daß die zum Stand der Technik beschriebenen Nachteile vermieden werden. Insbesondere soll eine zuverlässige Weiterkontaktierung für ein elektrisches Bauteil beziehungsweise ein entsprechend verbessertes piezoelektrisches Bauteil in Vielschichtbauweise angegeben werden.

Diese Aufgabe wird erfindungsgemäß gelöst durch die Weiterkontaktierung gemäß Patentanspruch 1 sowie das piezoelektrische Bauteil in Vielschichtbauweise gemäß Patentanspruch 9. Weitere Vorteile, Merkmale, Details, Aspekte und Effekte der Erfindung ergeben sich aus den Unteransprüchen, der Beschreibung sowie den Zeichnungen. Merkmale und Details, die im Zusammenhang mit der erfindungsgemäßen Weiterkontaktierung beschrieben sind, gelten dabei selbstverständlich auch für das piezoelektrische Bauteil, und umgekehrt.

Gemäß dem ersten Aspekt der Erfindung wird eine Weiterkontaktierung für ein elektrisches Bauteil, insbesondere für ein piezoelektrisches Bauteil in Vielschichtbauweise, bereitgestellt, die mehr als ein Verbindungselement, das heißt eine Anzahl von Verbindungselementen, zur Verbindung des elektrischen Bauteils mit einem elektrischen Anschlußelement aufweist. Die Weiterkontaktierung ist als ein einziges, strukturiertes Bauteil ausgebildet ist. Die Weiterkontaktierung ist erfindungsgemäß als eine einzige, strukturierte Folie ausgebildet.

Durch die erfindungsgemäße Ausgestaltung läßt sich eine zuverlässige Weiterkontaktierung realisieren, die, in elektrischen Bauteilen eingebaut, zu elektrischen Bauteilen mit einer hohen Belastbarkeit und Lebensdauer führt. Erfindungsgemäß wird eine Weiterkontaktierung bereitgestellt, bei der die mechanischen Belastungen im Bereich der Verbindungselemente erniedrigt sowie mögliche Resonanzen der elektrischen Anschlußelemente und damit verbundene mechanische Belastungen verringert werden. Dies läßt sich dadurch erreichen, daß die gesamte Weiterkontaktierung nunmehr nur noch als ein einziges Bauteil ausgebildet ist. Im Vergleich dazu bestanden die aus dem Stand der Technik bekannten Weiterkontaktierungen jeweils aus einer ganzen Anzahl von Einzelelementen, das heißt entsprechenden Verbindungselementen. Bei jedem dieser Verbindungselemente handelte es sich um ein von den jeweils anderen Verbindungselementen unabhängiges Bauteil. Durch die erfindungsgemäße Ausgestaltung der Weiterkontaktierung können nunmehr bei gleichzeitiger Erhöhung der Zuverlässigkeit auch Materialien verwendet werden, die sicherere und kostengünstigere Verarbeitungsprozesse ermöglichen. Beispiele für geeignete Materialien werden im weiteren Verlauf der Beschreibung näher erläutert.

Die erfindungsgemäße Weiterkontaktierung kann kostengünstig hergestellt werden und führt zu einer erhöhten Zuverlässigkeit eines mit der Weiterkontaktierung versehenen elektrischen Bauteils, beispielsweise eines piezoelektrischen Bauteils in Vielschichtbauweise, im dynamischen Betrieb.

Vorteilhaft kann die Weiterkontaktierung derart ausgebildet sein, daß jedes Verbindungselement mit einer einzigen, gemeinsamen Stromleitungsbahn verbunden ist. Da die Weiterkontaktierung nunmehr als ein einziges strukturiertes Bauteil ausgebildet ist, bilden sowohl die Verbindungselemente, als auch die gemeinsame Stromleitungsbahn integrale Bestandteile des strukturierten Bauteils, wodurch die Zuverlässigkeit der Weiterkontaktierung erhöht wird. So ist es beispielsweise nicht mehr erforderlich, die einzelnen Verbindungselemente über entsprechende Verbindungen, beispielsweise eine Lötverbindung, eine Schweißverbindung oder dergleichen mit einem Anschlußelement zu verbinden. Die Verbindung der Weiterkontaktierung erfolgt nunmehr über eine einzige Verbindung zwischen der Stromleitungsbahn und einem Anschlußelement. Diese Verbindung wird vorteilhaft in einem belastungsmäßig besonders geeigneten Bereich der Stromleitungsbahn realisiert, wie dies im weiteren Verlauf der Beschreibung noch näher erläutert wird.

Waren im Stand der Technik alle Verbindungselemente jeweils einzeln mit dem elektrischen Anschlußelement, bei dem es sich in der Regel um einen Kontaktstift oder dergleichen handelte, verbunden, so sind die Verbindungselemente nunmehr einteilig mit der Stromleitungsbahn verbunden. Durch die besondere Ausgestaltung der Stromleitungsbahn, beispielsweise in Folienform, weist diese eine im Vergleich zu den bisher verwendeten durchgehenden Kontaktstiften der herkömmlichen Lösungen wesentlich geringere Massebelegung auf, wodurch die bei den bekannten Lösungen auftretenden Eigenresonanzen in den Kontaktstiften nunmehr verringert werden können.

Die Erfindung ist nicht auf eine bestimmte Strukturierung der Weiterkontaktierung beschränkt. Vielmehr kann die Länge und Breite der Verbindungselemente, die Breite und Gestalt der Zwischenräume zwischen zwei benachbarten Verbindungselementen, die Ausgestaltung der Übergangsbereiche der Verbindungselemente zur Metallisierung beziehungsweise zur Stromleitungsbahn und dergleichen je nach Bedarf und Einsatzgebiet des elektrischen Bauteils gezielt ausgebildet werden.

In weiterer Ausgestaltung kann die Stromleitungsbahn eine im Vergleich zu jedem Verbindungselement größere Breite aufweisen. Auf diese Weise kann die in der Stromleitungsbahn gewünschte Stromdichte gezielt eingestellt werden. Vorteilhaft kann die Stromleitungsbahn eine sich über die Länge der Stromleitungsbahn ändernde Breite aufweisen. Auf diese Weise kann eine über die gesamte Länge der Stromleitungsbahn konstante Stromdichte erzielt werden.

Vorteilhaft kann das strukturierte Bauteil eine Kontaktierungszone aufweisen, in der ein elektrisches Anschlußelement angeordnet werden kann. Dabei kann das elektrische Anschlußelement beispielsweise, jedoch nicht ausschließlich, mittels Lötung, Schweißung oder dergleichen mit der Kontaktierungszone verbunden werden. Die Kontaktierungszone ist im strukturierten Bauteil vorzugsweise derart ausgebildet, daß die Verbindung zwischen Metallisierung und elektrischem Anschlußelement zu möglichst geringen mechanischen Belastungen führt. Einige Beispiele, wo und wie eine solche Verbindung zwischen Anschlußelement und Kontaktierungszone realisiert werden kann, sind im Zusammenhang mit dem erfindungsgemäßen piezoelektrischen Bauteil weiter unten beschrieben.

In weiterer Ausgestaltung kann die Weiterkontaktierung zumindest bereichsweise aus einem Material mit hoher elektrischer Leitfähigkeit gebildet sein. Durch die deutliche Verringerung der mechanischen Belastungen im Bereich der Weiterkontaktierung durch deren erfindungsgemäße Ausgestaltung können für die Weiterkontaktierung, beispielsweise die strukturierte Folie, nunmehr Werkstoffe eingesetzt werden, welche zwar mechanisch geringer belastbar sind, die aber eine für die Stromleitungsbahn ausreichende elektrische Leitfähigkeit besitzen und wesentlich kostengünstiger zu verarbeiten sind. Insbesondere kann die erfindungsgemäße Weiterkontaktierung nunmehr durch einfach zu realisierende Verfahren, wie beispielsweise Stanzen, lithographische Methoden oder dergleichen, hergestellt werden. Bei Auswahl geeigneter Materialien für die Weiterkontaktierung ist es beispielsweise weiterhin möglich, die Verbindungselemente mittels Laserlöten oder dergleichen mit der Metallisierung zu verbinden.

Die Erfindung ist nicht auf bestimmte Materialien für die Weiterkontaktierung beschränkt. Vorteilhaft weisen die Materialien jedoch eine Entfestigungstemperatur des Materials von > 150 °C auf, da viele Anwendungsgebiete für piezoelektrische Bauelemente in diesen Temperaturbereichen liegen. Weiterhin werden vorteilhaft solche Materialien verwendet, die beispielsweise mittels Weichlötung oder dergleichen gut mit anderen Werkstoffen verbindbar sind.

Vorteilhaft kann die Weiterkontaktierung aus wenigstens einem Material aus der Gruppe Cu, Cu-Legierung, Fe, Stahl, Ni-Basislegierung, Co-Basislegierung gebildet ist. Selbstverständlich sind auch andere Materialien denkbar. Wichtig ist lediglich, daß die verwendeten Materialien eine ausreichende Stromtragfähigkeit, beispielsweise im Bereich der Stromleitungsbahn, aufweisen.

Vorteilhaft kann die Weiterkontaktierung aus Stahl hergestellt sein. Hier eignen sich insbesondere rostfreie Stähle, die auf Grund ihres Gesamtpotentials sehr günstige Eigenschaften in bezug auf sehr hohe Dauerfestigkeiten, Entfestigungstemperaturen deutlich über 200 °C, standardmäßige Verfügbarkeit in Form dünnster Folien sowie niedrige Produktkosten aufweisen. Als geeignete Stähle können beispielsweise X12 NiCr 72 13, X10 CrNiTi 18 9, X40 CrMoV 20 5, X5 CrNi 18 9, X10 CrNi 18 8 und dergleichen eingesetzt werden.

Als Materialien auf Cu-Legierungsbasis eignen sich beispielsweise CuSn6, CuNi3Si1Mg, CuZn23Al3, CuCo2Be, CuNi2Be, CuBe2 und dergleichen. Als Ni-Basislegierungen können beispielsweise die NiCo-Legierungen Duratherm 600 sowie Nivaflex 45/5, oder aber auch NiBe2 und dergleichen verwendet werden. Als Co-Basislegierung eignet sich besonders gut Vacon CF8.

Die Weiterkontaktierung kann vorteilhaft zumindest bereichsweise von einem Passivierungsmaterial umgeben sein. Bei einem Passivierungsmaterial handelt es sich um eine Art Schutzmaterial und/oder Isolationsmaterial, welches beispielsweise aus einem Kunststoff gebildet sein kann. Eine elektrische Passivierung freiliegender elektrischer Bauelemente, wie beispielsweise elektrischen Verbindungselementen, elektrischen Verbindungsleitungen, den in einem piezoelektrischen Bauteil befindlichen Elektrodenschichten und dergleichen, ist erforderlich, um elektrische Überschläge und Kurzschlüsse zwischen benachbarten, freiliegenden elektrischen Bauteilen zu vermeiden.

Gemäß dem zweiten Aspekt der Erfindung wird ein piezoelektrisches Bauteil in Vielschichtbauweise bereitgestellt, bei dem alternierend immer eine piezoelektrische Keramikschicht und eine Elektrodenschicht zur Bildung eines Stapels übereinander angeordnet ist, bei dem jeweils wenigstens eine erste Elektrodenschicht und wenigstens eine im Stapel darauffolgende, zur ersten Elektrodenschicht benachbarte zweite Elektrodenschicht zur elektrischen Kontaktierung in alternierender Polarität jeweils mit zumindest einer seitlich am Stapel angeordneten Metallisierung verbunden ist, wobei jede Metallisierung über eine Weiterkontaktierung mit mehr als einem Verbindungselement elektrisch mit einem Anschlußelement verbunden ist. Das piezoelektrische Bauteil ist erfindungsgemäß dadurch gekennzeichnet, daß die Weiterkontaktierung in Form einer wie vorstehend beschriebenen erfindungsgemäßen Weiterkontaktierung ausgebildet ist.

Auf diese Weise werden piezoelektrische Bauteil mit einer zuverlässigen Weiterkontaktierung geschaffen, wobei die mechanischen Belastungen im Bereich der Weiterkontaktierung erniedrigt sowie mögliche Resonanzen in den elektrischen Anschlußelementen und die damit verbundenen mechanischen Belastungen verringert werden können.

Vorzugsweise kann der Schichtenstapel aus piezoelektrischen Keramikschichten und Elektrodenschichten auf einer Bodenplatte, vorzugsweise auf einer ruhenden Bodenplatte, angeordnet sein. Diese Bodenplatte kann vorteilhaft wenigstens eine Durchführung für das Anschlußelement aufweisen.

Vorteilhaft kann die Weiterkontaktierung als eine einzige strukturierte Folie ausgebildet sein, wobei jedes Verbindungselement mit einer einzigen, gemeinsamen Stromleitungsbahn verbunden ist. Vorzugsweise ist die Stromleitungsbahn in bezug auf jedes Verbindungselement auf der dem Stapel abgewandten Seite der Weiterkontaktierung ausgebildet. In diesem Fall kann jedes Verbindungselement auf der dem Stapel zugewandten Seite der Weiterkontaktierung mit der wenigstens einen Metallisierung verbunden sein. Durch die erfindungsgemäße Ausgestaltung der Weiterkontaktierung besteht zwischen den Verbindungselementen und der Stromleitungsbahn eine integrale Verbindung, so daß eine separate Verbindung, beispielsweise über eine Lötverbindung, eine Schweißverbindung oder dergleichen nur noch zwischen den Verbindungselementen und der Metallisierung realisiert werden muß.

Vorteilhaft kann die Stromleitungsbahn parallel zur Längsausrichtung des Stapels ausgerichtet sein.

Vorteilhaft kann dabei die Breite der Stromleitungsbahn vom freien Ende des Stapels aus gesehen hin in Richtung der Bodenplatte zunehmen.

In weiterer Ausgestaltung kann die Weiterkontaktierung eine Kontaktierungszone aufweisen, wobei die Kontaktierungszone im Bereich der Bodenplatte angeordnet ist, und wobei dort das Anschlußelement mit der Kontaktierungszone verbunden ist. Diese Ausgestaltung weist eine Reihe von Vorteilen auf. So liegt die Verbindung von der als ein einziges, strukturiertes Bauteil ausgebildeten Weiterkontaktierung und dem Anschlußelement, beispielsweise einem Kontaktstift, im Bereich der Bodenplatte, beispielsweise im Bereich der ruhenden Bodenplatte, und des im dynamischen Betrieb ebenfalls ruhenden Stapelbodens. Dadurch bleibt diese Verbindung mechanisch unbelastet.

Vorzugsweise kann die Weiterkontaktierung zumindest bereichsweise von einem Passivierungsmaterial umgeben sein, wobei der Stapel und die Weiterkontaktierung vorzugsweise in einem einzigen Hüllkörper aus Passivierungsmaterial angeordnet sind.

Dabei wird das strukturierte Bauteil der Weiterkontaktierung, beispielsweise die strukturierte Folie und hier insbesondere die Stromleitungsbahn bevorzugt in der Nähe, das heißt in unmittelbarer Umgebung des Stapels liegend mit dem Passivierungsmaterial, beispielsweise einem geeigneten Kunststoff vergossen. Damit wird auch die Stromleitungsbahn im dynamischen Betrieb homogen mit dem Stapel des piezoelektrischen Vielschichtbauelements mitgedehnt, wodurch die mechanischen Belastungen auf die Verbindungsstellen zwischen den Verbindungselementen und der Metallisierung sowie auf die Verbindungselemente selbst deutlich reduziert werden.

Dieser Mitführeffekt im dynamischen Betrieb wird insbesondere dadurch gewährleistet, daß der Abstand der Stromleitungsbahn zum Stapel bewußt möglichst gering gehalten wird.

In weiterer Ausgestaltung kann sich die Kontaktierungszone der Weiterkontaktierung im Ausgangszustand vom freien Ende des Stapels aus gesehen über den Stapel hinaus erstrecken, wobei das Anschlußelement zunächst auf der Rückseite der Kontaktierungszone angeordnet ist. Anschließend wird die Weiterkontaktierung im Bereich der Kontaktierungszone umgebogen, beispielsweise um 180°, so daß der Konstaktstift nunmehr auf der Vorderseite der Kontaktierungszone ausgebildet ist. Anschließend kann das Anschlußelement fixiert werden, beispielsweise indem es durch die in der Bodenplatte vorgesehene Durchführung hindurchgesteckt wird.

Auf diese Weise kann die Wahl und Durchführung der Verbindungsprozesse zwischen den Verbindungselementen und der Metallisierung, beziehungsweise dem Anschlußelement, weiter vereinfacht werden.

Wie weiter oben bereits ausführlich dargelegt wurde, ist eine geeignete Stromzuführung an den Stapel über die Verbindungselemente eine Vorbedingung, um den schädlichen Einfluß einzelner Polungsrisse im Bereich der Stapelkontaktierung, die beispielsweise eine Durchtrennung der Metallisierung und damit lokal inhomogene Auslenkungen hervorrufen können, beseitigen zu können. Durch das erfindungsgemäße Weiterkontaktierungsdesign, insbesondere durch die Verbindung der Weiterkontaktierung zum nach außen führenden Anschlußelement im ruhenden, nicht auslenkenden Bereich des piezoelektrischen Bauteils, können die mechanischen Belastungen in der als ein einziges, strukturiertes Bauteil ausgebildeten Weiterkontaktierung soweit reduziert werden, daß ein zwar mechanisch geringer belastbarer, aber ausreichend elektrisch leitfähiger Werkstoff eingesetzt werden kann.

Vorteilhaft kann ein wie vorstehend beschriebenes erfindungsgemäßes piezoelektrisches Bauteil als piezoelektrischer Aktor oder piezoelektrischer Wandler ausgebildet sein. Beispielhafte Ausführungsformen hierfür sind etwa Stapelaktoren, Transversalaktoren, Biegeaktoren, Wandler für medizinischen Ultraschall und dergleichen. Insbesondere kann das piezoelektrische Bauteil als Piezoaktor in Kfz-Einspritzsystemen, beispielsweise in Diesel-Einspritzsystemen eingesetzt werden.

Die Erfindung wird nun an Hand von Ausführungsbeispielen unter Bezugnahme auf die beiliegende Zeichnung näher erläutert. Es zeigen:
Figur 1 eine schematische Seitenansicht eines aus dem Stand der Technik bekannten piezoelektrischen Bauteils;
Figur 2 in Seitenansicht eine erste Ausführungsform eines erfindungsgemäßen piezoelektrischen Bauteils;
Figur 3 eine Draufsicht auf eine weitere Ausführungsform eines erfindungsgemäßen piezoelektrischen Bauteils; und
Figur 4 in Seitenansicht noch eine weitere Ausführungsform eines erfindungsgemäßen piezoelektrischen Bauteils.

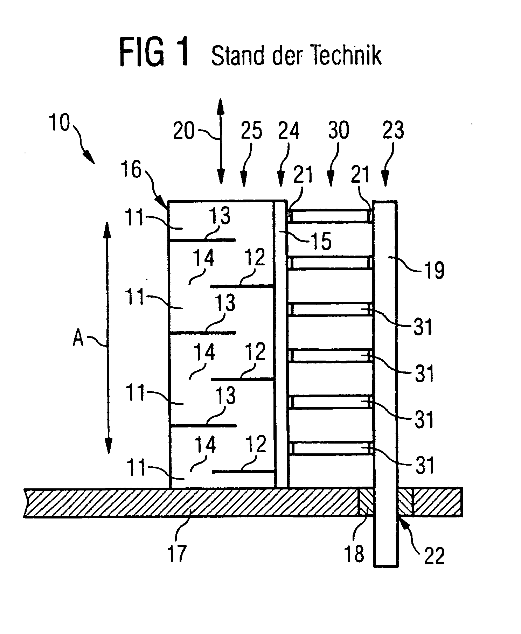

In Figur 1 ist zunächst ein aus dem Stand der Technik bekanntes piezoelektrisches Bauteil 10 in Vielschichtbauweise dargestellt, bei dem es sich um einen Piezoaktor handelt. Der Piezoaktor 10 besteht aus einem Stapel 16, bei dem alternierend immer eine piezoelektrische Keramikschicht 11 und eine Elektrodenschicht 12, 13 übereinander angeordnet ist. Jeweils wenigstens eine erste Elektrodenschicht 12 und wenigstens eine im Stapel 16 darauffolgende zur ersten Elektrodenschicht 12 benachbarten zweite Elektrodenschicht 13 sind zur elektrischen Kontaktierung in alternierender Polarität jeweils mit zumindest einer seitlich am Stapel 16 angeordneten Metallisierung 15 verbunden. Bei der Metallisierung 15 handelt es sich um ein durchgängiges Band, mit dem alle Elektrodenschichten 12 beziehungsweise 13 ein und derselben Polarität verbunden sind. Im Ausführungsbeispiel gemäß Figur 1 ist nur eine Metallisierung 15 dargestellt, über die alle Elektrodenschichten 12 verbunden sind.

Die Metallisierungen 15 sind in einem Bereich des Stapels 16 angeordnet, in dem dieser jeweils inaktive Isolationszonen 14 aufweist.

Der Stapel 16 ist auf einer ruhenden Bodenplatte 17 angeordnet, die eine mit Isolationsmitteln 18 ausgekleidete Durchführung 22 zum Hindurchführen eines elektrischen Anschlußelements 19 aufweist. Das elektrische Anschlußelement 19 hat die Aufgabe, den Stapel 16, das heißt die Elektrodenschichten 12 beziehungsweise 13 mit einem elektrischen Strom zu beaufschlagen. Dazu ist das elektrische Anschlußelement 19 über eine Weiterkontaktierung 30 mit der Metallisierung 15 verbunden. Bei dem aus dem Stand der Technik bekannten piezoelektrischen Aktor 10 gemäß Figur 1 besteht die Weiterkontaktierung 30 aus einer Anzahl von eigenständigen Verbindungselementen 31, bei denen es sich beispielsweise um dünne Drähte handelt. Die einzelnen Verbindungselemente 31 sind über geeignete Verbindungen 21, beispielsweise Lötverbindungen, Schweißverbindungen oder dergleichen mit dem elektrischen Anschlußelement 19 beziehungsweise der Metallisierung 15 verbunden. Die Verbindung der Verbindungselemente 31 mit der Metallisierung 15 erfolgt dabei an der dem Stapel 16 zugewandten Seite 24 der Verbindungselemente 31, während die Verbindung mit dem Anschlußelement 19 an der dem Stapel abgewandten Seite 23 der Verbindungselemente 31 erfolgt. Die Verbindungselemente 31, beziehungsweise das elektrische Anschlußelement 19, sind in der Regel zusammen mit dem Aktorstapel 16 in einer Kunststoffumhüllung gemeinsam vergossen.

Im dynamischen Betrieb des Piezoaktors 10 bleiben die Bodenplatte 17, das elektrische Anschlußelement 19 und der Boden des Stapels 16 in Ruhe, während der Hub an dem mit dem Doppelpfeil 20 gekennzeichneten freien Ende 25 des Stapels 16 stattfindet. Der Stapel 16 und damit der Piezoaktor 10 führen somit eine Längsbewegung in Richtung der Längsausrichtung A des Stapels 16 aus. Im Bereich des freien Endes 25 des Stapels 16 werden damit die Verbindungselemente 31 maximaler mechanischer Belastung ausgesetzt, was die Materialauswahl einschränkt und an die Verbindungstechnik zwischen den Verbindungselementen 31 und der Metallisierung 15, beziehungsweise dem elektrischen Anschlußelement 19, erhöhte Anforderungen stellt. Das elektrische Anschlußelement 19 und die Verbindungselemente 31 können darüber hinaus im dynamischen Betrieb zu Longitudinal- oder Transversalschwingungen angeregt werden, die zusätzliche mechanische Belastungen im Bereich der Weiterkontaktierung 30 verursachen.

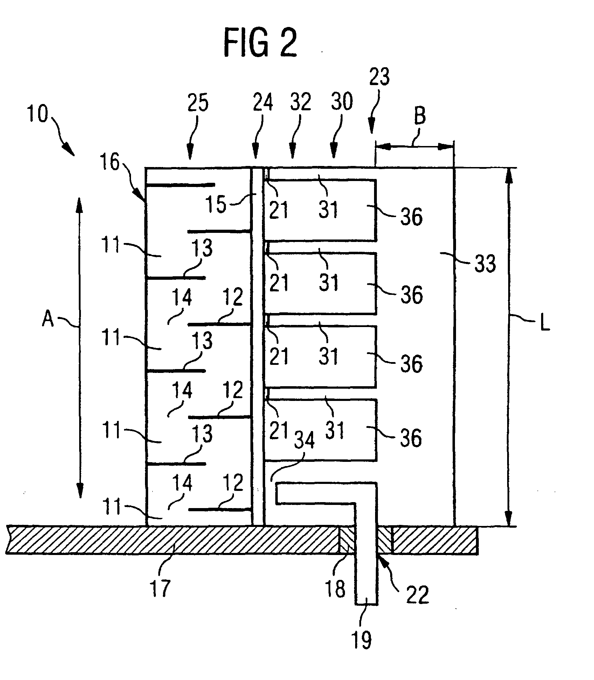

Figur 2 zeigt ein Ausführungsbeispiel für eine erfindungsgemäße Lösung, mit der diese schädlichen mechanischen Belastungen zuverlässig reduziert werden können. Dabei entspricht der piezoelektrische Aktor 10 in seinem Grundaufbau dem in Figur 1 dargestellten piezoelektrischen Aktor 10, so daß gleiche Bauteile mit identischen Bezugsziffern versehen wird, und zur Vermeidung von Wiederholungen auf eine erneute Beschreibung dieser Bauteile verzichtet und dafür Bezug auf die Ausführungen zu Figur 1 genommen wird.

Im Unterschied zu der in Figur 1 dargestellten Ausführungsform weist der piezoelektrische Aktor 10 gemäß Figur 2 nunmehr eine Weiterkontaktierung 30 auf, die nicht mehr (wie in Figur 1) aus einer ganzen Anzahl eigenständiger, separater Verbindungselemente 31 besteht. Vielmehr ist die Weiterkontaktierung nunmehr als ein einziges, strukturiertes Bauteil 32 ausgebildet, im vorliegenden Ausführungsbeispiel als strukturierte Metallfolie 32. Die Metallfolie 32 kann bevorzugt aus Kupfer oder Kupferlegierungen hergestellt sein. Die strukturierte Folie 32 weist nach wie vor eine Anzahl von Verbindungselementen 31 auf, die jedoch einteilig mit einer Stromleitungsbahn 33 verbunden sind. Dadurch weist die Metallfolie 32 eine Art "Kammstruktur" auf, bei der die einzelnen Verbindungselemente 31 die "Kammzähne" bilden und von der Stromleitungsbahn 33 abragen. Zwischen einzelnen, benachbarten Verbindungselementen 31 sind jeweils Zwischenräume 36 vorgesehen.

Stromleitungsbahn 33 und Verbindungselemente 31 bilden somit ein integrales Bauteil, so daß entsprechende Verbindungen 21 zwischen den Verbindungselementen 31 und der Stromleitungsbahn 33 nunmehr entfallen können. Die Weiterkontaktierung 30 muß nunmehr nur noch an der dem Stapel 16 zugewandten Seite 24 mit der Metallisierung 15 verbunden werden, was wiederum über geeignete Löt- oder Schweißverbindungen 21 erfolgen kann. Auf der dem Stapel 16 abgewandten Seite 23 der Verbindungselemente 31 ist nunmehr die Stromleitungsbahn 33 vorgesehen, die vorteilhaft eine im Vergleich zu den Verbindungselementen 31 größere Breite B aufweist.

Die Weiterkontaktierung 30 beziehungsweise die Stromleitungsbahn 33 kann im Vergleich zum Stapel 16 derart ausgerichtet sein, daß sich diese in ihrer Längenrichtung L in paralleler Ausrichtung zur Längsausrichtung A des Stapels 16 befindet.

Weiterhin weist die Weiterkontaktierung 30 eine Kontaktierungszone 34 auf, in der ein elektrisches Anschlußelement 19 mit der Weiterkontaktierung 30 verbunden ist. Das elektrische Anschlußelement 19 kann in der wie in Figur 1 beschriebenen Art und Weise durch die Bodenplatte 17 hindurchgeführt werden oder sein.

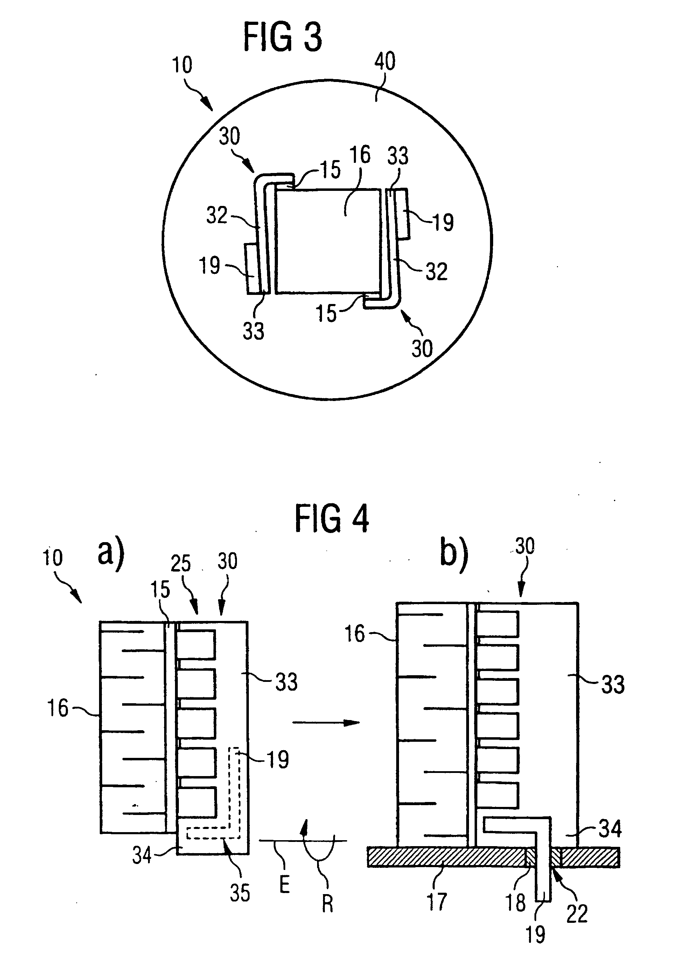

Die erfindungsgemäße Ausgestaltung der Weiterkontaktierung 30 führt zu einer Reihe von Vorteilen. Zunächst liegt die Verbindung der Weiterkontaktierung 30, das heißt der strukturierten Folie 32, mit dem elektrischen Anschlußelement 19 im Bereich der ruhenden Bodenplatte 17 und des auch im dynamischen Betrieb ruhenden Bodens des Stapels 16, so daß diese im Betrieb des piezoelektrischen Aktors 10 mechanisch unbelastet bleibt. Weiterhin werden die strukturierte Folie 32 und insbesondere die Stromleitungsbahn 33 bevorzugt in der Nähe des Stapels 16 liegend mit Kunststoff vergossen. Dies ist auch in Figur 3 dargestellt. Damit wird auch die Stromleitungsbahn 33 im dynamischen Betrieb homogen mit dem Stapel 16 mitgedehnt, wodurch die mechanischen Belastungen auf die Verbindungen 21 zwischen den Verbindungselementen 31 und der Metallisierung 15 sowie auf die Verbindungselemente 31 selbst deutlich reduziert werden. Die geringe Massebelegung der Stromleitungsbahn 33 im Vergleich zum in Figur 1 dargestellten durchgehenden elektrischen Anschlußelement 19 der herkömmlichen Lösung verringert in Verbindung mit dem Verguß in ein Passivierungsmaterial (siehe Figur 3) mögliche eigene Resonanzen.

Durch die deutliche Verringerung der mechanischen Belastungen im Bereich der Weiterkontaktierung 30 können für die strukturierte Folie 32 Werkstoffe eingesetzt werden, die zwar mechanisch geringer belastbar sind, die aber die für die Stromleitungsbahn 33 erforderliche gute elektrische Leitfähigkeit besitzen und wesentlich kostengünstiger zu verarbeiten sind.

In Figur 3 ist eine Draufsicht auf einen in einen Hüllkörper 40 aus Passivierungsmaterial eingebetteten piezoelektrischen Aktor 10 dargestellt. In dem Ausführungsbeispiel gemäß Figur 3 ist der Abstand der Weiterkontaktierung 30 und hier insbesondere der Stromführungsbahn 33 zum Stapel 16 bewußt möglichst gering gehalten, um einen Mitführeffekt im dynamischen Betrieb des piezoelektrischen Aktors 10 zu gewähren. Die Auswahl des Passivierungsmaterials erfolgt je nach Ausgestaltungsform und Einsatzgebiet des Piezoaktors 10. Vorteilhaft kann das Passivierungsmaterial beispielsweise als Kunststoff ausgebildet sein.

In Figur 4 ist schließlich eine weitere Ausführungsvariante eines wie in Figur 2 dargestellten erfindungsgemäßen piezoelektrischen Aktors 10 dargestellt, so daß bezüglich des Grundaufbaus auf die Ausführungen zu Figur 2 verwiesen wird.

Figur 4a stellt eine strukturierte Folie 32 dar, bei dem sich die Kontaktierungszone 34 im Ausgangszustand vom freien Ende 25 des Stapels 16 aus gesehen zunächst über den Stapel 16 hinaus erstreckt, so daß eine über den Stapel 16 hinaus verlängerte Kontaktierungszone 34 vorliegt. Das elektrische Anschlußelement 19 wird zunächst auf der Rückseite 35 der Kontaktierungszone 34 angeordnet, was durch die gestrichelte Darstellung verdeutlicht ist. Anschließend wird, wie in Figur 4b dargestellt, die strukturierte Folie 32 im Bereich der Kontaktierungszone 35 in Biegerichtung R um die Biegeebene E herum um 180° gebogen und das Anschlußelement 19 anschließend in der Durchführung 22 der Bodenplatte 17 fixiert. Auf diese Weise kann die Wahl und Durchführung der Verbindungsprozesse der Weiterkontaktierung 30 mit der Metallisierung 15 und dem Anschlußelement 19 weiter vereinfacht werden.

## Patentansprüche

1. Weiterkontaktierung für ein elektrisches Bauteil, insbesondere für ein piezoelektrisches Bauteil.in Vielschichtbauweise, mit mehr als einem Verbindungselement (31) zur Verbindung des elektrischen Bauteils mit einem elektrischen Anschlußelement, wobei die Weiterkontaktierung (30) als ein einziges, strukturiertes Bauteil (32) ausgebildet ist,
**dadurch gekennzeichnet, daß** die Weiterkontaktierung (30) als eine einzige, strukturierte Folie (32) ausgebildet ist.

2. Weiterkontaktierung nach Anspruch 1, **dadurch gekennzeichnet, daß** jedes Verbindungselement (31) mit einer einzigen, gemeinsamen Stromleitungsbahn (33) verbunden ist.

3. Weiterkontaktierung nach Anspruch 2, **dadurch gekennzeichnet, daß** die Stromleitungsbahn (33) eine im Vergleich zu-jedem Verbindungselement (31) größere Breite (B) aufweist.

4. Weiterkontaktierung nach Anspruch 2 oder 3, **dadurch gekennzeichnet, daß** die Stromleitungsbahn (33) eine sich über die Länge (L) der Stromleitungsbahn (33) ändernde Breite (B) aufweist.

5. Weiterkontaktierung nach einem der Ansprüche 1 bis 4, **dadurch gekennzeichnet, daß** das strukturierte Bauteil (32) eine Kontaktierungszone (34) aufweist, in der ein elektrisches Anschlußelement angeordnet werden kann.

6. Weiterkontaktierung nach einem der Ansprüche 1 bis 5, **dadurch gekennzeichnet , daß** die Weiterkontaktierung (30) zumindest bereichsweise aus einem Material mit hoher elektrischer Leitfähigkeit gebildet ist.

7. Weiterkontaktierung nach Anspruch 6, **dadurch gekennzeichnet, daß** die Weiterkontaktierung (30) aus wenigstens einem Material aus der Gruppe Cu, Cu-Legierung, Fe, Stahl, Ni-Basislegierung, Co-Basislegierung gebildet ist.

8. Weiterkontaktierung nach einem der Ansprüche 1 bis 7, **dadurch gekennzeichnet, daß** die Weiterkontaktierung (30) zumindest bereichsweise von einem Passivierungsmaterial umgeben ist.

9. Piezoelektrisches Bauteil in Vielschichtbauweise, bei dem alternierend immer eine piezoelektrische Keramikschicht (11) und eine Elektrodenschicht (12, 13) zur Bildung eines Stapels (16) übereinander angeordnet ist, bei dem jeweils wenigstens eine erste Elektrodenschicht (12) und wenigstens eine im Stapel (16) darauffolgende, zur ersten Elektrodenschicht (12) benachbarte zweite Elektrodenschicht (13) zur elektrischen Kontaktierung in alternierender Polarität jeweils mit zumindest einer seitlich am Stapel (16) angeordneten Metallisierung (15) verbunden ist, wobei jede Metallisierung (15) über eine Weiterkontaktierung (30) mit mehr als einem Verbindungselement (31) elektrisch mit einem Anschlußelement (19) verbunden ist, **dadurch gekennzeichnet, daß** die Weiterkontaktierung nach einem der Ansprüche 1 bis 9 ausgebildet ist.

10. Piezoelektrisches Bauteil nach Anspruch 9, **dadurch gekennzeichnet, daß** der Stapel (16) auf einer Bodenplatte (17), vorzugsweise auf einer ruhenden Bodenplatte, angeordnet ist.

11. Piezoelektrisches Bauteil nach Anspruch 9 oder 10, **dadurch gekennzeichnet, daß** die Bodenplatte (17) wenigstens eine Durchführung (22) für das Anschlußelement (19) aufweist.

12. Piezoelektrisches Bauteil nach einem der Ansprüche 9 bis 11, **dadurch gekennzeichnet, daß** die Weiterkontaktierung (30) als eine einzige strukturierte Folie (32) ausgebildet ist, daß jedes Verbindungselement (31) mit einer einzigen gemeinsamen Stromleitungsbahn (33) verbunden ist und.daß die Stromleitungsbahn (33) in bezug auf jedes Verbindungselement (31) auf der dem Stapel (16) abgewandten Seite (23) der Weiterkontaktierung (30) ausgebildet ist.

13. Piezoelektrisches Bauteil nach Anspruch 12, **dadurch gekennzeichnet, daß** jedes Verbindungselement (31) auf der dem Stapel (16) zugewandten Seite (24) der Weiterkontaktierung (30) mit der wenigstens einen Metallisierung (15) verbunden ist.

14. Piezoelektrisches Bauteil nach Anspruch 12 oder 13, **dadurch gekennzeichnet, daß** die Stromleitungsbahn (33) parallel zur Längsausrichtung (A) des Stapels (16) ausgerichtet ist.

15. Piezoelektrisches Bauteil nach einem der Ansprüche 12 bis 14, soweit diese auf Anspruch 11 oder 12 rückbezogen sind, **dadurch gekennzeichnet, daß** die Breite (B) der Stromleitungsbahn (33) vom freien Ende (25) des Stapels (16) aus gesehen hin in Richtung der Bodenplatte (17) zunimmt.

16. Piezoelektrisches Bauteil nach einem der Ansprüche 10 bis 15, **dadurch gekennzeichnet, daß** die Weiterkontaktierung (30) eine Kontaktierungszone (34) aufweist, daß die Kontaktierungszone (34) im Bereich der Bodenplatte (17) angeordnet ist und daß das Anschlußelement (19) mit der Kontaktierungszone (34) verbunden ist.

17. Piezoelektrisches Bauteil nach einem der Ansprüche 9 bis 16, **dadurch gekennzeichnet, daß** die Weiterkontaktierung (30) zumindest bereichsweise von einem Passivierungsmaterial umgeben ist und daß der Stapel (16) und die Weiterkontaktierung (30) vorzugsweise in einem einzigen Hüllkörper (40) aus Passivierungsmaterial angeordnet sind.

18. Piezoelektrisches Bauteil nach einem der Ansprüche 9 bis 17, **dadurch gekennzeichnet, daß** sich die Kontaktierungszone (34) der Weiterkontaktierung (30) im Ausgangszustand vom freien Ende (25) des Stapels (16) aus gesehen über den Stapel (16) hinaus erstreckt und daß das Anschlußelement (29) auf der Rückseite (35) der Kontaktierungszone (34) angeordnet ist.

19. Piezoelektrisches Bauteil nach einem der Ansprüche 9 bis 18, **dadurch gekennzeichnet, daß** dieses als piezoelektrischer Aktor oder piezoelektrischer Wandler ausgebildet ist.

## Claims

1. Additional contacting for an electrical component, especially for a piezoelectric component in the form of a multilayer structure, with more than one connecting element (31) for connecting the electrical component with an electrical connection element, the additional contacting (30) being configured as a single, structured component (32), **characterised in that**, the additional contacting (30) is configured as a single, structured foil (32).

2. Additional contacting according to Claim 1, **characterised in that** each connecting element (31) is connected to a single, shared current conductor track (33).

3. Additional contacting according to Claim 2, **characterised in that** the current conductor track (33) has a greater width (B) compared to each connecting element (31).

4. Additional contacting according to Claim 2 or 3, **characterised in that** the width (B) of the current conductor track (33) changes over the length (L) of the current conductor track (33).

5. Additional contacting according to one of Claims 1 to 4, **characterised in that** the structured component (32) features a contacting zone (34) in which an electrical connection element can be arranged.

6. Additional contacting according to one of Claims 1 to 5, **characterised in that** the additional contacting (30) is formed in at least some areas from a material with higher electrical conductivity.

7. Additional contacting according to Claim 6, **characterised in that** the additional contacting (30) is formed from at least one material from the group Cu, Cu alloy, Fe, steel, Ni basic alloy, Co basic alloy.

8. Additional contacting according to one of the Claims 1 to 7, **characterised in that** the additional contacting (30) is surrounded in at least some areas by a passivation material.

9. Multilayer construction piezoelectric component in which a piezoelectric ceramic layer (11) and an electrode layer (12, 13) are always arranged alternately one above the other to form a stack (16), in which at least one first electrode layer (12) and at least one second electrode layer (13) following on from it in the stack (16) adjacent to the first electrode layer (12) are each connected for electrical contacting in alternating polarity with at least one metallisation (15) located to the side of the stack (16) with each metallisation (15) being connected via an additional contacting (30) with more than one connecting element (31) connected electrically to an connection element (19), **characterised in that** the additional contacting is embodied in accordance with one of Claims 1 to 9.

10. Piezoelectric component according to Claim 9, **characterised in that** the stack (16) is located on a base plate (17), preferably on a static base plate.

11. Piezoelectric component according to Claim 9 or 10, **characterised in that** the base plate (17) features at least one through-hole (22) for the connection element (19).

12. Piezoelectric component according to one of the Claims 9 to 11, **characterised in that** the additional contacting (30) is embodied as a single structured foil (32) that each connecting element (31) is connected to a single shared current conductor track (33) and that the current conductor track (33) in relation to each connecting element (31) is embodied on the side (23) of the additional contacting (30) away from the stack (16).

13. Piezoelectric component according to Claim 13, **characterised in that** each connecting element (31) on the side (24) of the additional contacting (30) away from the stack (16) is connected with the at least one metallisation (15).

14. Piezoelectric component according to Claim 12 or 13, **characterised in that** the current conductor track (33) is aligned in parallel to the lengthwise alignment (A) of the stack (16).

15. Piezoelectric component according one of the Claims 12 to 14, provided these are referred back to Claim 11 or 12, **characterised in that** the width (B) of the current conductor track (33) seen from the free end (25) of the stack (16) increases in the direction of the base plate (17).

16. Piezoelectric component according to one of Claims 10 to 15, **characterised in that** the additional contacting (30) features a contacting zone (34), that the contacting zone (34) is arranged in the area of the base plate (17) and that the connection element (19) is connected with the contacting zone (34).

17. Piezoelectric component according to one of Claims 9 to 16, **characterised in that** the additional contacting (30) is at least in some areas surrounded by a passivation material and that the stack (16) and the additional contacting (30) are preferably located in an individual enclosure (40) made from passivation material.

18. Piezoelectric component according to one of Claims 9 to 17, **characterised in that** the contacting zone (34) of the additional contacting (30) in its initial state, seen from the free end of (25) the stack (16) extends beyond the stack (16) and that the connection element (29) is located on the back (35) of the contacting zone (34).

19. Piezoelectric component according to one of Claims 9 to 18, **characterised in that** this is embodied as a piezoelectric actor or piezoelectric converter.

## Revendications

1. Dispositif de transmission de contact pour un élément électrique, notamment un élément piézoélectrique de construction multicouches, comprenant plus d'un élément de connexion (31) permettant de connecter l'élément électrique à un élément de raccordement électrique, le dispositif de transmission de contact (30) étant réalisé sous la forme d'un seul élément structuré (32), **caractérisé en ce que** le dispositif de transmission de contact (30) est réalisé sous la forme d'une seule feuille structurée (32).

2. Dispositif de transmission de contact selon la revendication 1, **caractérisé en ce que** chaque élément de connexion (31) est connecté à une seule et même piste de conduction de courant commune (33).

3. Dispositif de transmission de contact selon la revendication 2, **caractérisé en ce que** la piste de conduction de courant (33) présente une largeur (B) supérieure à celle de chaque élément de connexion (31).

4. Dispositif de transmission de contact selon la revendication 2 ou 3, **caractérisé en ce que** la piste de conduction de courant (33) présente une largeur (B) variant sur la longueur (L) de la piste de conduction de courant (33).

5. Dispositif de transmission de contact selon l'une des revendications 1 à 4, **caractérisé en ce que** l'élément structuré (32) présente une zone de mise en contact (34) dans laquelle peut être disposé un élément de raccordement électrique.

6. Dispositif de transmission de contact selon l'une des revendications 1 à 5, **caractérisé en ce que** le dispositif de transmission de contact (30) est formé, au moins dans certaines zones, en un matériau présentant une conductivité électrique élevée.

7. Dispositif de transmission de contact selon la revendication 6, **caractérisé en ce que** le dispositif de transmission de contact (30) est formé en au moins un matériau issu du groupe Cu, alliage de Cu, Fe, acier, alliage à base de Ni, alliage à base de Co.

8. Dispositif de transmission de contact selon l'une des revendications 1 à 7, **caractérisé en ce que** le dispositif de transmission de contact (30) est entouré, du moins dans certaines zones, par un matériau de passivation.

9. Elément piézoélectrique de construction multicouches, dans lequel sont superposées respectivement de manière alternée une couche céramique piézoélectrique (11) et une couche d'électrodes (12, 13) pour former une pile (16), dans lequel au moins une première couche d'électrodes (12) et au moins une deuxième couche d'électrodes (13) voisine de la première couche d'électrodes (12) et succédant à celle-ci dans la pile (16) sont respectivement connectées, en vue d'établir le contact électrique en polarité alternée, à au moins une métallisation (15) disposée latéralement sur la pile (16), chaque métallisation (15) étant électriquement connectée à un élément de raccordement (19) par l'intermédiaire d'un dispositif de transmission de contact (30) comportant plus d'un élément de connexion (31), **caractérisé en ce que** le dispositif de transmission de contact est formé selon l'une des revendications 1 à 9.

10. Elément piézoélectrique selon la revendication 9, **caractérisé** e n ce que la pile (16) est disposée sur une plaque de fond (17), de préférence sur une plaque de fond immobile.

11. Elément piézoélectrique selon la revendication 9 ou 10, **caractérisé en ce que** la plaque de fond (17) présente au moins un passage (22) pour l'élément de raccordement (19).

12. Elément piézoélectrique selon l'une des revendications 9 à 11, **caractérisé en ce que** le dispositif de transmission de contact (30) est réalisé sous la forme d'une seule feuille structurée (32), **en ce que** chaque élément de connexion (31) est connecté à une seule et même piste de conduction de courant commune (33), et **en ce que** la piste de conduction de courant (33) est formée par rapport à chaque élément de connexion (31) sur le côté (23) du dispositif de transmission de contact (30) qui est opposé à la pile (16).

13. Elément piézoélectrique selon la revendication 12, **caractérisé en ce que** chaque élément de connexion (31) est connecté, sur le côté (24) du dispositif de transmission de contact (30) qui est tourné vers la pile (16), à la métallisation (15), dont il existe au moins une.

14. Elément piézoélectrique selon la revendication 12 ou 13, **caractérisé en ce que** la piste de conduction de courant (33) est orientée parallèlement au sens longitudinal (A) de la pile (16).

15. Elément piézoélectrique selon l'une des revendications 12 à 14, dans la mesure où celles-ci se rapportent à la revendication 11 ou 12, **caractérisé en ce que** la largeur (B) de la piste de conduction de courant (33) augmente depuis l'extrémité libre (25) de la pile (16) vers la plaque de fond (17).

16. Elément piézoélectrique selon l'une des revendications 10 à 15, **caractérisé en ce que** le dispositif de transmission de contact (30) présente une zone de mise en contact (34), **en ce que** ladite zone de mise en contact (34) est disposée dans la zone de la plaque de fond (17), et **en ce que** l'élément de raccordement (19) est connecté à la zone de mise en contact (34).

17. Elément piézoélectrique selon l'une des revendications 9 à 16, **caractérisé en ce que** le dispositif de transmission de contact (30) est entouré, du moins dans certaines zones, par un matériau de passivation, et **en ce que** la pile (16) et le dispositif de transmission de contact (30) sont de préférence disposés dans un seul et unique corps enveloppant (40) en matériau de passivation.

18. Elément piézoélectrique selon l'une des revendications 9 à 17, **caractérisé en ce que** la zone de mise en contact (34) du dispositif de transmission de contact (30) dépasse, à l'état initial, et ce vu depuis l'extrémité libre (25) de la pile (16), ladite pile (16), et **en ce que** l'élément de raccordement (29) est disposé sur la face arrière (35) de la zone de mise en contact (34).

19. Elément piézoélectrique selon l'une des revendications 9 à 18, **caractérisé en ce que** celui-ci est réalisé sous forme d'actionneur piézoélectrique ou de convertisseur piézoélectrique.
